# EUROPEAN PATENT APPLICATION

(11) **EP 2 322 943 A1**
(43) Date of publication of application: **18.05.2011**
(21) Application number: 09805088.3
(22) Date of filing: 10.08.2009
(51) Int. Cl.: G01R 1/073, G01R 1/067, H01H 1/04, H01L 21/66, H01R 13/03, H01R 13/24

(54) **ELECTRIC CONTACT MEMBER AND CONTACT PROBE**

(30) Priority: 08.08.2008 JP 2008206238
(71) Applicant: NHK Spring Co., Ltd., Kanagawa 236-0004 (JP)
(72) Inventor: KAZAMA, Toshio, Kamiina-gun Nagano 399-4301 (JP); TAKAMURA, Noritoshi, Aikou-gun Kanagawa 243-0303 (JP); KAWARABAYASHI, Tomohiro, Kamiina-gun Nagano 399-4301 (JP)
(74) Representative: HOFFMANN EITLE
(86) International application number: PCT/JP2009/064140
(87) International publication number: WO 2010/016608

(57) **Abstract**

An electrical contact member and a contact probe that are durable and economical are provided. For this purpose, an outer peripheral portion, which has a symmetrical shape with respect to a central axis in a longitudinal direction and has a hollow portion, and a core portion, which has an approximate bar shape extending in the longitudinal direction and filling the hollow portion, are included. One of the outer peripheral portion and the core portion is made of a noble metal alloy, and the other is made of a conductive material other than the noble metal alloy. The one of the outer peripheral portion and the core portion, which is made of the noble metal alloy, projects further than the other at one end portion in the longitudinal direction.

## Description

### Field

The present invention relates to an electrical contact member and a contact probe that is formed by using the electrical contact member.

### Background

Conventionally, there is known a technology in which, when an electrical characteristics test for a semiconductor integrated circuit such as an IC chip is performed, a conductive contact probe is used to transmit a test signal to the semiconductor integrated circuit (see, for example, Patent Literature 1). In this technology, a portion to be brought into contact with an electrode of the semiconductor integrated circuit or an electrode of a circuit substrate that transmits the test signal is constructed of a needle-shaped electrical contact member. To improve the conductivity of the contact probe, the surface of the electrical contact member is usually plated with noble metal such as gold or silver.

As the number of tests increases, solder on the electrode of the semiconductor integrated circuit or on the electrode of the circuit substrate is increasingly transferred onto the vicinity of a tip portion of the electrical contact member in the contact probe. Therefore, the electrical resistance increases, the electrical characteristics test cannot be performed normally. To prevent such situations, it is necessary to periodically perform an operation of scrapping off the solder attached to the tip end of the contact probe by using sandpaper or the like.

### Citation List

### Patent Literature

Patent Literature 1: Japanese Laid-open Patent Publication No. 2001-33480

### Summary

### Technical Problem

In the conventional contact probe as described above, when the solder attached to the tip end is scraped off, the plating film is caused to flake off and become thinner. As the plating film becomes thinner, a cycle for scrapping off the solder tends to become shorter, which eventually makes it necessary to exchange the contact probe.

To enable the contact probe to be used for a long period of time even with the operation for scrapping off the solder attached to the tip end, it has been studied to use a solid noble metal material for forming the electrical contact member. In this case, however, because expensive noble metal is used in large quantities, there is a problem in that the contact probe becomes expensive.

The present invention has been made in view of the above, and it is an object of the present invention to provide an electrical contact member and a contact probe that are durable and economical.

### Solution to Problem

To solve the problem described above and achieve the object, an electrical contact member according to the present invention includes: an outer peripheral portion that has a symmetrical shape with respect to a central axis in a longitudinal direction and has a hollow portion; and a core portion that has an approximate bar shape extending in the longitudinal direction and filling the hollow portion, wherein one of the outer peripheral portion and the core portion is made of a noble metal alloy and the other one of the outer peripheral portion and the core portion is made of a conductive material different from the noble metal alloy.

In the invention described above, the one of the outer peripheral portion and the core portion, the one being made of the noble metal alloy, projects at one end portion in the longitudinal direction further than the other one of the outer peripheral portion and the core portion.

A contact probe according to the present invention includes a first electrical contact member that includes an outer peripheral portion that has a symmetrical shape with respect to a central axis in a longitudinal direction and has a hollow portion; a core portion that has an approximate bar shape extending in the longitudinal direction and filling the hollow portion; a second electrical contact member that includes an outer peripheral portion that has a symmetrical shape with respect to a central axis in a longitudinal direction and has a hollow portion; and a core portion that has an approximate bar shape extending in the longitudinal direction and filling the hollow portion; and a spring member which is made of a conductive material extendable in an axis direction and of which both end portions in the axis direction are respectively attached to the first electrical contact member and the second electrical contact member, wherein one of the outer peripheral portion and the core portion of each of the first electrical contact member and the second electrical contact member projects further than the other one of the outer peripheral portion and the core portion at a longitudinal end portion of each of the first electrical contact member and the second electrical contact member on a side that is not connected to the spring member, the projected one of the outer peripheral portion and the core portion is made of a noble metal alloy, and the other one of the outer peripheral portion and the core portion is made of a conductive material other than the noble metal alloy.

### Advantageous Effects of Invention

According to the present invention, an electrical contact member includes an outer peripheral portion, which has a symmetrical shape with respect to a central axis in a longitudinal direction and has a hollow portion, and a core portion, which has an approximate bar shape extending in the longitudinal direction and filling the hollow portion. One of the outer peripheral portion and the core portion is made of a noble metal alloy and the other is made of a conductive material different from the noble metal alloy. Accordingly, it is possible to use the noble metal alloy at a portion that is brought into contact with a contact object, and suppress the use amount of the noble metal alloy. Therefore, it is possible to provide an electrical contact member that is durable and economical, and a contact probe having the electrical contact member.

### Brief Description of Drawings

FIG. 1 is a diagram illustrating a configuration of a contact probe according to an embodiment of the present invention.
FIG. 2 is a vertical cross-sectional view illustrating a configuration of a first plunger of the contact probe according to the embodiment of the present invention.
FIG. 3 is a vertical cross-sectional view illustrating a configuration of a second plunger of the contact probe according to the embodiment of the present invention.
FIG. 4 is a diagram illustrating a configuration of a relay contact as an electrical contact member according to another embodiment of the present invention.
FIG. 5 is a vertical cross-sectional view of FIG. 4.

### Description of Embodiments

Best modes for carrying out the present invention (hereinafter, "embodiments") are explained below with reference to the accompanying drawings. It should be noted that the drawings are schematic and a relation between the thickness and the width of each portion, a ratio of the thicknesses of the respective portions, and the like may be different from realistic ones. It goes without saying that the drawings may depict some portion as having different relations and ratios of dimensions.

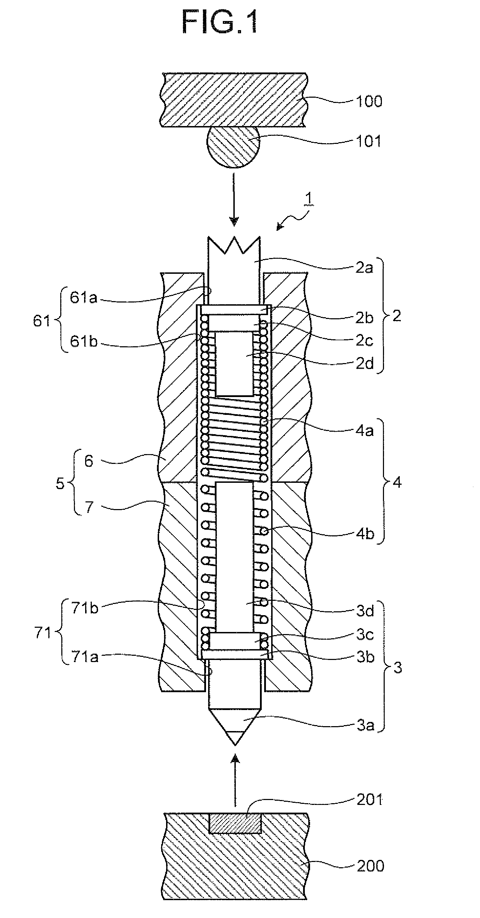

FIG. 1 is a diagram illustrating a configuration of a contact probe according to an embodiment of the present invention. A contact probe 1 illustrated in the figure includes a first plunger 2 and a second plunger 3, both of which have respective tip portions oriented in opposite directions, and a spring member 4 that connects the first plunger 2 and the second plunger 3 to each other and is extendable in a longitudinal direction (a vertical direction in FIG. 1).

The contact probe 1 is housed in a probe holder 5, electrically connects a semiconductor integrated circuit 100, such as an IC chip, as a test object and a circuit substrate 200 that outputs a test signal, and performs transmission and reception of electrical signals. When the semiconductor integrated circuit 100 is tested, the first plunger 2 is brought into contact with a connection electrode 101 arranged on the semiconductor integrated circuit 100, and the second plunger 3 is brought into contact with a connection electrode 201 arranged on the circuit substrate 200. Thus, one of the first plunger 2 and the second plunger 3 functions as a first electrical contact member and the other functions as a second electrical contact member.

The first plunger 2 includes a tip portion 2a having a tip end in a crown shape, a flange portion 2b having a diameter larger than the diameter of the tip portion 2a, a boss portion 2c which projects in an opposite direction of the tip portion 2a via the flange portion 2b, which is in the form of a cylinder with a diameter that is smaller than the diameter of the flange portion 2b, and onto which the end portion of the spring member 4 is press fitted, and a base end portion 2d which is in the form of a cylinder with a diameter that is smaller than the diameter of the boss portion 2c and which extends from the boss portion 2c in a direction opposite to the flange portion 2b. The first plunger 2 has a symmetrical shape with respect to a central axis in the longitudinal direction.

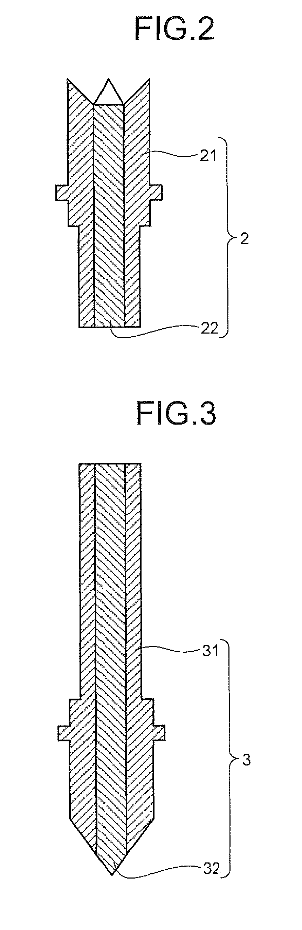

FIG. 2 is a vertical cross-sectional view illustrating the configuration of the first plunger 2. The first plunger 2 includes an outer peripheral portion 21 having a hollow portion, and a cylindrical (round-bar-shaped) core portion 22 that extends in the longitudinal direction and fills the hollow portion of the outer peripheral portion 21. The outer peripheral portion 21 has a crown shape at an upper tip portion out of the tip portions of the first plunger 2 in FIG. 2, and projects in the longitudinal direction further than the core portion 22. Therefore, the upper end of the outer peripheral portion 21 comes into contact with the connection electrode 101 when the semiconductor integrated circuit 100 is tested. The crown shape of the outer peripheral portion 21 may be formed by, for example, grooving machining during lathe machining.

The outer peripheral portion 21 is made of a noble metal alloy. For example, an alloy mainly consisting of silver (Ag), palladium (Pd), gold (Au), platinum (Pt), zinc (Zn), copper (Cu), iron (Fe), and nickel (Ni), an alloy mainly consisting of palladium, silver, and copper, or an alloy mainly consisting of silver, platinum, zinc, gold, and copper may be applied as the noble metal alloy. The core portion 22 is made of a conductive material such as copper or aluminum, which is cheaper than the noble metal alloy. Accordingly, the contact probe can be used for a long period of time while an operation of scraping off solder, which is attached to the tip portion of the outer peripheral portion 21 by repeating tests, can be performed periodically. Further, the use amount of the noble metal alloy can be suppressed, enabling to reduce costs.

The first plunger 2 having the above configuration is formed by performing lath machining on a pencil-shaped workpiece, of which outer peripheral side is made of a noble metal alloy corresponding to the outer peripheral portion 21 and of which core portion on the inner peripheral side is made of a conductive material corresponding to the core portion 22.

The second plunger 3 includes a tip portion 3a having a sharp tip end, a flange portion 3b having a diameter larger than the diameter of the tip portion 3a, a boss portion 3c which projects in an opposite direction of the tip portion 3a via the flange portion 3b, which is in the form of a cylinder with a diameter that is smaller than the diameter of the flange portion 3b, and onto which the end portion of the spring member 4 is press fitted, and a base end portion 3d which is in the form of a cylinder with a diameter that is smaller than the diameter of the boss portion 3c and which extends from the boss portion 3c in a direction opposite to the flange portion 3b. The second plunger 3 has a symmetrical shape with respect to a central axis parallel to the longitudinal direction.

FIG. 3 is a vertical cross-sectional view illustrating the configuration of the second plunger 3.
The second plunger 3 includes an outer peripheral portion 31 having a hollow portion, and a core portion 32 which has an approximate bar shape extending in the longitudinal direction and filling the hollow portion of the outer peripheral portion 31, and of which bottom end in FIG. 3 is formed as a sharp tip end. The core portion 32 projects in the longitudinal direction further than the outer peripheral portion 31 at the bottom end portion out of the tip portions of the second plunger 3 in FIG. 3. Therefore, the bottom end of the core portion 32 comes into contact with the connection electrode 201 of the circuit substrate 200.

The outer peripheral portion 31 is made of the same conductive material as that of the core portion 22. The core portion 32 is made of the same noble metal alloy as that of the outer peripheral portion 21. Therefore, the second plunger 3 has an advantage in that it is durable and economical, similarly to the first plunger 2.

The second plunger 3 having the above configuration is formed by performing lathe machining on a pencil-shaped workpiece, of which outer peripheral side is made of a conductive material corresponding to the outer peripheral portion 31 and of which core portion on the inner peripheral side is made of a noble metal alloy corresponding to the core portion 32.

The spring member 4 is a coil spring that has a uniform diameter and is made of a conductive material extendable in an axis direction. The spring member 4 includes a tightly wound portion 4a on one side that is attached to the first plunger 2, and a loosely wound portion 4b on the other side that is attached to the second plunger 3. The inner diameter of the spring member 4 is slightly smaller than the outer diameters of the boss portions 2c and 3c. An end portion of the tightly wound portion 4a is in contact with the flange portion 2b, and an end portion of the loosely wound portion 4b is in contact with the flange portion 3b.

When the semiconductor integrated circuit 100 is tested, the spring member 4 is compressed and curved due to the load applied by the first plunger 2 and the second plunger 3. Accordingly, at least a portion of the tightly wound portion 4a is brought into contact with the base end portion 3d. Therefore, an electrical connection is established with the shortest path via the first plunger 2, the spring member 4, and the second plunger 3 in sequence. By establishing the electrical connection with the shortest path as described above, it is possible to suppress increase in the inductance of the contact probe 1 at the time of a test.

The configuration of the probe holder 5 will be described below. The probe holder 5 houses a plurality of contact probes 1 in a pattern corresponding to an arrangement pattern of the connection electrode 101 such that both ends of each contact probe 1 are exposed to the outside. The probe holder 5 is formed by stacking, in the thickness direction, a first holder member 6 and a second holder member 7, each of which is formed in a plate shape by using an insulating material, such as synthetic resin, having high insulation property. The first holder member 6 and the second holder member 7 are bonded together or fixed to each other with a screw or the like.

A plurality of insertion holes 61, which pierce through the first holder member in the thickness direction and into which the contact probes 1 are inserted, is formed on the first holder member 6. Each insertion hole 61 has a stepped-hole shape formed of a small diameter portion 61a and a large diameter portion 61b. The small diameter portion 61a has an opening on the side (an upper surface side in FIG. 1) facing the semiconductor integrated circuit 100 as a test object. The large diameter portion 61b has an opening on the side facing the second holder member 7. The flange portion 2b is brought into contact with a stepped portion that is the boundary between the small diameter portion 61a and the large diameter portion 61b, so that the first plunger 2 is prevented from coming off from the first holder member 6.

A plurality of insertion holes 71, which pierce through the second holder member in the thickness direction and into which the contact probes 1 are inserted, is formed on the second holder member 7. The insertion holes 71 communicate with the respective insertion holes 61. Each insertion hole 71 has a stepped-hole shape formed of a small diameter portion 71a and a large diameter portion 71b. The small diameter portion 71a has an opening on the side (a bottom surface side of FIG. 1) facing the circuit substrate 200. The large diameter portion 71b has an opening on the side facing the first holder member 6. The flange portion 3b is brought into contact with the stepped portion that is the boundary between the small diameter portion 71a and the large diameter portion 71b, so that the second plunger 3 is prevented from coming off from the second holder member 7.

A synthetic resin material with good insulation property may be used as an insulating material for forming the first holder member 6 and the second holder member 7.
A resin material with good slidability, machinable ceramics, teflon (registered trademark), or the like may be used as the insulating material.

The insertion holes 61 and 71 are formed by performing drilling, etching, or punching or by performing any of machining methods such as laser machining, electron beam machining, ion beam machining, or wire electrical discharge machining on an insulating material as a base material.

The ratio between the thickness of the first holder member 6 and the thickness of the second holder member 7 can appropriately be set depending on the shape or the like of the contact probe 1 to be housed.

According to the embodiment of the present invention described above, a noble metal alloy is applied to a portion that is brought into contact with a connection object, and a conductive material that is cheaper than the noble metal alloy is applied to the inner periphery or the outer periphery. Therefore, it is possible to provide an electrical contact member and a contact probe that are durable and economical.

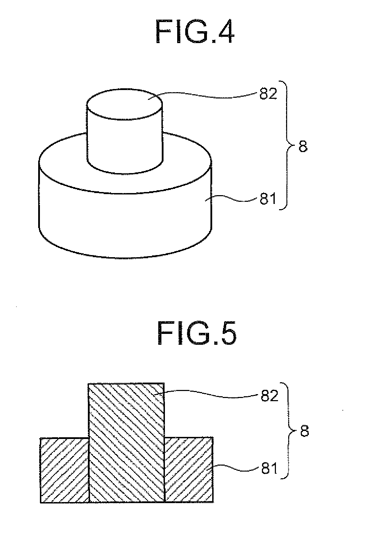

The embodiment is explained in detail above as best modes for carrying out the present invention; however, the present invention should not be limited to the embodiments. For example, the present invention may be applied to an electrical contact member other than ones described above. FIG. 4 is a diagram illustrating a configuration of a relay contact as an electrical contact member according to another embodiment of the present invention. FIG. 5 is a vertical cross-sectional view of FIG. 4. A relay contact 8 illustrated in FIG. 4 and FIG. 5 includes a base portion 81 in the form of a hollow disk and a cylindrical projection 82 which fills a hollow portion of the base portion 81 and of which one end projects from the hollow portion. The projection 82 is made of a noble metal alloy. The base portion 81 is made of a conductive material different from the noble metal alloy (more preferably, a conductive material cheaper than the noble metal alloy). With the relay contact 8 having the above configuration, similarly to the first plunger 2 and the second plunger 3 described above, it is possible to achieve the advantage of durability and economic efficiency.

As described above, the present invention can include various embodiments and the like not described here, and various design changes and the like can be made in the range without departing from the technical idea as specified by the claims.

### Industrial Applicability

The present invention is useful for forming an electrical contact of an electrical circuit. More specifically, the present invention is useful for forming an electrical contact used in an apparatus that performs an electrical characteristics test on a semiconductor integrated circuit or the like.

### Reference Signs List

- 1: CONTACT PROBE
- 2: FIRST PLUNGER
- 2a, 3a: TIP PORTION
- 2b, 3b: FLANGE PORTION
- 2c, 3c: BOSS PORTION
- 2d, 3d: BASE END PORTION
- 3: SECOND PLUNGER
- 4: SPRING MEMBER
- 4a: TIGHTLY WOUND PORTION
- 4b: LOOSELY WOUND PORTION
- 5: PROBE HOLDER
- 6: FIRST HOLDER MEMBER
- 7: SECOND HOLDER MEMBER
- 8: RELAY CONTACT
- 21, 31: OUTER PERIPHERAL PORTION
- 22, 32: CORE PORTION
- 61, 71: INSERTION HOLE
- 61a, 71a: SMALL DIAMETER PORTION
- 61b, 71b: LARGE DIAMETER PORTION
- 81: BASE PORTION
- 82: PROJECTION
- 100: SEMICONDUCTOR INTEGRATED CIRCUIT
- 101, 201: CONNECTION ELECTRODE
- 200: CIRCUIT SUBSTRATE

## Claims

1. An electrical contact member comprising:
an outer peripheral portion that has a symmetrical shape with respect to a central axis in a longitudinal direction and has a hollow portion; and
a core portion that has an approximate bar shape extending in the longitudinal direction and filling the hollow portion, wherein
one of the outer peripheral portion and the core portion is made of a noble metal alloy and the other one of the outer peripheral portion and the core portion is made of a conductive material different from the noble metal alloy.

2. The electrical contact member according to claim 1, wherein
the one of the outer peripheral portion and the core portion, the one being made of the noble metal alloy, projects at one end portion in the longitudinal direction further than the other one of the outer peripheral portion and the core portion.

3. A contact probe comprising:
a first electrical contact member that includes
an outer peripheral portion that has a symmetrical shape with respect to a central axis in a longitudinal direction and has a hollow portion;
a core portion that has an approximate bar shape extending in the longitudinal direction and filling the hollow portion;
a second electrical contact member that includes
an outer peripheral portion that has a symmetrical shape with respect to a central axis in a longitudinal direction and has a hollow portion; and
a core portion that has an approximate bar shape extending in the longitudinal direction and filling the hollow portion; and
a spring member which is made of a conductive material extendable in an axis direction and of which both end portions in the axis direction are respectively attached to the first electrical contact member and the second electrical contact member, wherein
one of the outer peripheral portion and the core portion of each of the first electrical contact member and the second electrical contact member projects further than the other one of the outer peripheral portion and the core portion at a longitudinal end portion of each of the first electrical contact member and the second electrical contact member on a side that is not connected to the spring member,
the projected one of the outer peripheral portion and the core portion is made of a noble metal alloy, and
the other one of the outer peripheral portion and the core portion is made of a conductive material other than the noble metal alloy.
